# EUROPÄISCHE PATENTSCHRIFT

(11) **EP 1 923 712 B1**
(45) Veröffentlichungstag und Bekanntmachung des Hinweises auf die Patenterteilung: **12.06.2013**
(21) Anmeldenummer: 07022059.5
(22) Anmeldetag: 14.11.2007
(51) Int. Cl.: G01R 33/34, G01R 33/36

(54) **Verfahren zum Abstimmen eines HF-Resonatorsystems**
Method for adjusting an HF resonator system
Procédé d'ajustement d'un système de résonateur HF

(30) Priorität: 14.11.2006 DE 102006053472
(43) Veröffentlichungstag der Anmeldung: 21.05.2008
(73) Patentinhaber: Bruker BioSpin AG, 8117 Fällanden (CH)
(72) Erfinder: Freytag, Nicolas, 8122 Binz (CH)
(74) Vertreter: Kohler Schmid Möbus

(56) Entgegenhaltungen:
- JP-A- 5 056 948
- JP-A- 5 199 007
- US-A- 5 466 480
- US-A1- 2004 021 466
- US-B1- 6 169 399
- KONEVAL D J ET AL: "Improved VHF filter crystals using insulating film techniques" SYMP FREQUENCY CONTROL; SYMPOSIUM ON FREQUENCY CONTROL, 1966, Seiten 103-130, XP002467550

## Beschreibung

Die Erfindung betrifft ein Verfahren zum Abstimmen eines Hochfrequenz(HF)-Resonatorsystem, insbesondere für einen Magnetresonanz(MR)-Probenkopf, umfassend mindestens einen HF-Resonator mit einem Substrat, auf dem eine leitfähige Struktur aufgebracht ist, wobei die leitfähige Struktur Bereiche von kapazitiven und induktiven Elementen umfasst, und die kapazitiven Elemente in Form von Fingerkapazitäten ausgebildet sind.

Derartige HF-Resonatorsysteme sind aus [7] und den darin zitierten Referenzen, sowie aus [3] bekannt.

Für MR-Anwendungen werden HF-Resonatorsysteme zum Einstrahlen von HF-Pulsen und Detektieren von HF-Signalen aus den Messproben verwendet. Ein HF-Resonatorsystem kann dabei einen oder mehrere HF-Resonatoren umfassen. Bei hochauflösenden MR-Apparaturen kann die Empfindlichkeit der Apparatur durch Verwendung von Hochtemperatursupraleiter(=HTS)-Resonatoren gesteigert werden. Derartige Resonatoren werden in der Regel lithografisch aus HTS-Filmen auf planaren Substraten strukturiert. Dabei können jedoch Fehler in der Lithographie entstehen, die es beim Bau eines MR-Probenkopfes zu kompensieren gilt. Diese Fehler können sich beispielsweise durch eine Erhöhung oder Erniedrigung der Resonanzfrequenz eines Resonators bemerkbar machen.

Im Folgenden wird zwischen "Tunen" und "Trimmen" unterschieden. Der Begriff "Tunen" beschreibt einen Mechanismus, bei dem die Resonanzfrequenz eines Resonators oder Resonatorsystems reversibel verändert werden kann, und zwar unter den Einsatzbedingungen, für die das System vorgesehen ist. Im Falle eines Kernspinmagnetresonanz(=NMR)-Probenkopfes ist dieses Tunen notwendig, um Frequenzänderungen des mit Messproben beladenen Resonatorsystems in Bezug auf das leere Resonatorsystem zu korrigieren. Die Resonanzfrequenz des Resonatorsystems verändert sich beim Einführen einer Messprobe, da die Resonatoren neben den magnetischen Feldern die zum Senden und Empfangen der Kernspinresonanzsignale verwendet werden auch elektrische Felder im Probenvolumen generieren. Da die Messproben verschiedene Dielektrizitätskonstanten aufweisen (bei Raumtemperatur ist ε ≈ 80 für Wasser, ε ≈ 21 für Aceton, ε ≈ 4.8 für Chloroform und ε ≈ 2.2 für Benzol) muss beim Wechsel der Messprobe die Resonanzfrequenz des Probenkopfes neu eingestellt werden.

Der Begriff "Trimmen" bezeichnet einen Mechanismus, der die Resonanzfrequenz eines Resonators oder Resonatorsystems einmalig einstellt und zwar vor oder zur Fertigstellung des Produktes. Im Falle eines NMR-Probenkopfes bezeichnet das Trimmen das Einstellen einer Resonanzfrequenz des Resonatorsystems, so dass der Tuningbereich der entsprechenden Apparatur ausreichend ist, um mit allen Messproben auf die Resonanzfrequenz der Messkeme im gegebenen statischen Magnetfeld B₀ abstimmbar zu sein. Das Trimmen bezieht sich folglich sowohl auf die Korrektur von Fehlern, die beim Herstellen von Resonatoren entstehen als auch auf Methoden, bei denen die Resonatoren beabsichtigt mit einer Resonanzfrequenz höher oder tiefer als die vorgegebene Zielfrequenz gefertigt werden und anschließend getrimmt werden. Diese Methode kann die Ausbeute im Herstellungsprozess erhöhen.

Eine gängige Methode zum Trimmen von Resonatoren für NMR-Probenköpfe ist es die Resonanzfrequenz der Spulen durch Lasertrimmen einzustellen. Dies ist z.B. bekannt aus Referenz [2] für den Fall von Spiralresonatoren, für welche diese Methode sehr einfach und erfolgreich funktioniert. In der NMR werden aber auch andere Typen von Resonatoren verwendet, insbesondere solche mit vielen ineinander verschachtelten Leiterbahnen, so genannte "Resonatoren mit lokalisierten Kapazitäten" bzw. auch "Resonatoren mit verteilten Kapazitäten".

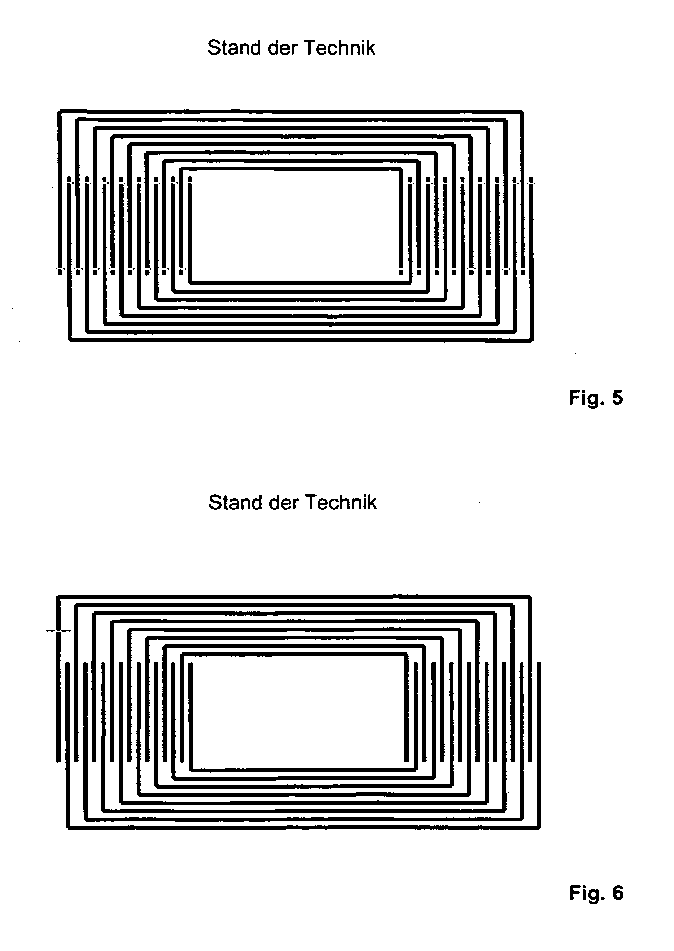

Bei solchen Resonatoren ist es am sinnvollsten möglichst alle Kapazitäten gleichmäßig zu trimmen, indem die Überlapplängen der Leiterbahnen gekürzt werden, wie in Fig. 5 gezeigt. Problematisch ist hierbei, dass bei realistischen Ausführungsformen die Abstände zwischen den Leiterbahnen lediglich 2-10 µm betragen, so dass es schwierig ist die Leiterbahnen zu unterbrechen ohne benachbarte Leiterbahnen zu beschädigen. Weiterhin müssten die geschnittenen Leiterbahnen verrundet werden um keine Spitzen zu generieren, an denen Entladungen im Resonanzfall entstehen können. Problematisch ist hierbei insbesondere, dass die höchsten Spannungsdifferenzen zwischen benachbarten Leiterbahnen an den Enden der Fingerkondensatoren auftreten, d.h. am Ort der "Beschädigung" durch das Lasertrimmen. Experimentell stellt man rasch fest, dass derart getrimmte Spulen zum "Schießen" neigen, d.h. elektrische Durchschläge im Betrieb aufweisen und dadurch in der Regel unbrauchbar werden.

Diese Problematik ist bei Spiralresonatoren weniger gegeben, da die lokalen elektrischen Feldstärken (d.h. die Spannung zwischen benachbarten Leiterelementen) hier deutlich niedriger ausfallen als bei anderen Resonatortypen. Allerdings lassen sich solche Spiralresonatoren in der NMR nur sehr begrenzt einsetzen, da ihre Resonanzfrequenzen niedrig und die elektrischen Felder und damit die dielektrischen Verluste in den Messproben und Frequenzshifts beim Probenwechsel sehr hoch ausfallen. Weiterhin ist ihre Stromtragefähigkeit begrenzt.

Aus Referenz [7] sind Resonatoren bekannt, bei denen jedes Leiterelement einzeln getrimmt werden muss, da sonst die Vorzüge der angepassten Stommaxima in den einzelnen Leiterbahnen verloren gehen. Dies bedingt allerdings, dass die Leiterbahnen sauber geschnitten werden und die Schnitte "verrundet" werden können. Lasersysteme mit so hoher mechanischer Auflösung im Sub-Mikrometer Bereich sind extrem teuer, das Trimmen ist zeitaufwändig und damit ineffizient.

Eine alternative Methode des Lasertrimmens besteht darin in "digitalen" Schritten zu trimmen. Dabei wird ein einzelner "Finger" des Resonators abgeschnitten (Fig. 6). Dadurch wird die gesamte Leiterbahn (und eventuell eine zweite, die mit dieser Leiterbahn gekoppelt ist) quasi stromfrei und es baut sich keine Spannung mehr auf. Dies verhindert Durchschläge an der getrimmten Leiterbahn. Nachteilig ist allerdings, dass bei dieser Methode nur noch ein Teil der Leiterbahnen Strom tragen und die Verteilung der Ströme über die Leiterbahnen ungleichmäßig ist. Weiterhin lässt sich der Resonator nur relativ grob trimmen, feine Schritte sind nicht möglich.

Ein weiterer entscheidender Nachteil von Lasertrimm-Verfahren ist, dass es sich um einen irreversiblen Prozess handelt. Ist der Frequenzshift zu groß ausgefallen, kann nicht mehr korrigiert werden und der Resonator ist unbrauchbar.

Alternativ zum Lasertrimmen kann mittels chemischer oder mechanischer Ätzprozesse die leitende Struktur so verändert werden, dass die Resonanzfrequenz entsprechend eingestellt wird. Auch in diesem Falle ist das Trimmen jedoch irreversibel, und der Aufwand ist enorm, da ein Ausrichten der Maskierung auf den Resonator im Sub-Mikrometer Bereich erreicht werden muss. Vorteilhaft in Bezug auf das Lasertrimmen ist, dass die Strukturierung mit derselben hohen Qualität wie die ursprüngliche ausgeführt werden kann, d.h. es entstehen durch das Trimmen keine "Beschädigungen", die zu elektrischen Durchschlägen führen. Die einzige realistische Methode zur Ausführung eines solchen Trimmverfahrens ist allerdings das Direktschreiben der Struktur mittels Laser oder Elektronenstrahl auf eine Photomaske. Dieses Verfahren ist erneut extrem kostspielig und zeitaufwändig.

Ein weiteres Problem beim Aufbau eines Probenkopfes entsteht dadurch, dass die Montage der Substrate zueinander gewisse Toleranzen aufweist. Hierdurch variiert die Resonanzfrequenz des Helmholtzmodes, der beispielsweise für die NMR genutzt wird über mehrere MHz, im besten Falle um ca. 1-2% (entsprechend etwa 1 MHz für Protonen). In Referenz [6] wird diese bekannte Eigenschaft gekoppelter Resonatoren ausgenutzt um ein Tuning des Modes zu erlauben. Für HTS-Resonatorsysteme, die in der hochauflösenden NMR verwendet werden, ist dies jedoch völlig ungeeignet, da das Bewegen von Resonatoren zum Tuning im statischen Magnetfeld aufgrund des Landau-Effektes zu massiven Verzerrungen des statischen Magnetfeldes B₀ führt. Diese Methode eignet sich für die hochauflösende NMR daher nur zum Trimmen, nicht zum Tunen des Resonators.

Um diese Montagetoleranzen auszugleichen kann der Tuningbereich des Probenkopfes ausreichend weit gewählt werden, so dass die Resonanzfrequenz dennoch eingestellt werden kann. Nachteilig ist allerdings, dass alle gängigen Methoden zum Tunen von HTS-Resonatoren zu Güte und/oder Effizienzverlusten der Resonatoren führen. Aus diesem Grund ist ein übermäßig großer Tuningbereich nicht wünschenswert.

Alternativ können diese Fehler nach der Montage mittels Verstellschrauben kompensiert werden und die Resonatoren erst dann endgültig befestigt werden, wenn die Resonanzfrequenz korrekt eingestellt ist. Dies erfordert allerdings hohen mechanischen Aufwand, da die Positionierung auf ca. 100 µm genau erfolgen muss.

Im Bereich der Mikrowellentechnik ist ein Verfahren zum Trimmen von dielektrischen Resonatoren mittels lokaler Metallisierungen bekannt [1].

Für Filter ist es darüber hinaus bekannt, dielektrische Körper ("Tuning-Elemente") im Bereich der elektrischen Felder der Resonatoren zu bewegen um die Eigenresonanzen der Resonatoren zu verändern [3], [4]. Alternativ ist es auch bekannt die Massenebene in Bezug auf die Resonatoren zu verändern und hierdurch die Resonanzfrequenz zu verändern [5].

Aufgabe der Erfindung ist es, ein Verfahren zum Abstimmen eines Resonatorsystems vorzuschlagen, bei dem der Ausschuss aufgrund von Herstellungsfehlern gering ist.

Diese Aufgabe wird erfindungsgemäß durch ein Verfahren gemäß Patentanspruch 1 gelöst.

Die leitfähige Struktur des durch das erfindungsgemäße Verfahren hergestellen Resonatorsystems ist zumindest in den Bereichen der kapazitiven Elemente mit mindestens einer dielektrischen Schicht beschichtet, welche die Bereiche der kapazitiven Elemente zumindest teilweise bedeckt , wobei die lokale Dicke mindestens einer der dielektrischen Schichten abhängig von der Resonanzfrequenz des unbeschichteten HF-Resonators, von einer vorgegebenen Resonanzfrequenz des fertig beschichteten Resonators, von der Dielektrizitätskonstante des Substrats und von den Dielektrizitätskonstanten der Materialien der dielektrischen Schichten eingestellt ist.

Die gewünschte Resonanzfrequenz des Resonatorsystems ist durch die lokale Dicke der dielektrischen Schichten und ihren Dielektrizitätskonstanten bestimmt, welche über die Fläche des Resonators variieren kann. Dielektrische Schichten, welche die oben beschriebene Abhängigkeit, nämlich von der vorgegebenen Resonanzfrequenz des fertig beschichteten Resonators, der Dielektrizitätskonstante des Substrats und der Dielektrizitätskonstante der Materialien der dielektrischen Schichten, aufweist, werden im Folgenden als "Trimmschichten" bezeichnet. Neben mindestens einer Trimmschicht kann das erfindungsgemäße Resonatorsystem noch weitere dielektrische Schichten umfassen, deren Dicke und Dielektrizitätskonstante die Dicke der Trimmschichten beeinflussen.

Besonders vorteilhaft erweist sich das HF-Resonatorsystem wenn die leitfähigen Strukturen Hochtemperatursupraleiter(HTS)material enthalten. HTS-Resonatoren werden beispielsweise in der hochauflösenden NMR, der bildgebenden MR (MRI) und der Quadrupolresonanzspektroskopie (NQR) verwendet, da sie aufgrund ihrer geringen elektrischen Verluste zu einer massiven Verbesserung des Signal zu Rauschverhältnisses führen. Weiterhin finden Sie in Hochfrequenzfiltern, z.B. für Telekommunikationsanwendungen, Radarsysteme etc. Verwendung, da mittels HTS-Resonatorstrukturen besonders rauscharme, verlustarme Filter mit zugleich hoher Flankensteilheit gebaut werden können.

Besonders einfach lässt sich ein HF-Resonatorsystem herstellen, wenn die lokale Dicke mindestens einer der dielektrischen Schichten über die gesamte Fläche der Schicht konstant ist. Besonders bevorzugt ist eine Ausführungsform, bei der die lokale Dicke der Schicht in allen Bereichen des HF-Resonators, insbesondere sogar des gesamten Substrates denselben Wert aufweist.

Am einfachsten und daher auch am kostengünstigsten herstellbar ist ein HF-Resonatorsystem wenn zumindest eine der dielektrischen Schichten die Bereiche der kapazitiven Elemente vollständig bedeckt. Dabei kann die Trimmschicht zugleich die Funktion einer Schutzschicht gegen elektrische Durchschläge übernehmen.

Vorteilhafterweise enthält zumindest eine der dielektrischen Schichten ein Material mit einer Dielektrizitätskonstante im Bereich zwischen 2 und 26.

Vorteilhaft ist es, wenn zumindest eine der dielektrischen Schichten ein Material enthält, welches gegen Lösungsmittel, insbesondere gegen Alkohol und/oder Aceton und/oder Wasser, chemisch resistent, und, insbesondere für Wasserdampf, nicht permeabel ist. Auf diese Weise wird gewährleistet, dass das Resonatorsystem mit gängigen Reinigungsprozessen kompatibel ist und die Trimmschicht kann zugleich als Schutzschicht für die empfindlichen Resonatorstrukturen gegen chemische und mechanische Beschädigungen verwendet werden.

Um eine hohe Güte des Resonatorsystems zu realisieren, ist es vorteilhaft, wenn zumindest eine der dielektrischen Schichten ein Material enthält, welches eine elektrische Leitfähigkeit s mit s < 10⁻³ S/m, vorzugsweise s < 10⁻⁵ S/m, insbesondere s < 10⁻⁸ S/m, und/oder einen geringen Verlustfaktor tan δ aufweist, wobei tan δ < 10⁻³, insbesondere tan δ < 10⁻⁵.

Vorzugsweise bestehen die dielektrischen Schichten aus Materialien, welche eine weitestgehend temperaturunabhängige Dielektrizitätskonstante aufweisen. Unter "weitestgehend temperaturunabhängig" ist eine maximale Abweichung der Dielektrizitätskonstante von 10 % innerhalb eines Temperaturbereichs von 15 K bis Raumtemperatur, vorzugsweise weniger als 1 % in einem Temperaturbereich von 10 K bis 90 K, zu verstehen. Dies reduziert die Anforderungen and die Stabilität der Temperierung der Resonatoren im Betrieb.

Besonders geeignet sind HF-Resonatorsysteme, bei denen zumindest eine der dielektrischen Schichten Polymere, insbesondere Parylene, und/oder fluorierte Polymere, insbesondere Perfluorethylenpropylen-Copolymer (=FEP), Perfluoralkoxy-Copolymer (=PFA), Polytetrafluorethylen (=PTFE), und/oder Oxyde und/oder Nitride enthält. Insbesondere Parylene haben den Vorzug, dass deren Abscheidung bei Raumtemperatur oder kälter vollständig isotrop aus der Gasphase erfolgen kann. Dies ist besonders bei HTS-Resonatorsystemen von Vorteil, da eine Abscheidung aus der Gasphase das Risiko der Beschädigung des HTS-Filmes durch Überhitzung oder Lösungsmittel und Säuren/Laugen, verringert.

Um Entladungen vorzubeugen ist es von Vorteil, wenn zumindest eine der dielektrischen Schichten, insbesondere diejenige Schicht, die direkt auf und um die kapazitiven Elemente des Resonatorsystems aufgebracht ist, eine Spannungsfestigkeit aufweist, die größer als 10⁷ V/m, insbesondere größer als 10⁸ V/m ist.

Vorzugsweise weist das Material der dielektrischen Schicht eine ähnliche Dielektrizitätskonstante wie das Substrat auf, wobei die Dielektrizitiätskonstante der dielektrischen Schicht insbesondere zwischen dem halben und dem doppelten Wert der Dielektrizitätskonstante des Substrates liegt.

Insbesondere bei HF-Resonatorsystemen mit sehr dünnen Beschichtungen ist es vorteilhaft, wenn die Dielektrizitätskonstanten der dielektrischen Schichten, mit steigendem Abstand von den leitfähigen Strukturen abnehmen. Insbesondere ist es von Vorteil, wenn die erste Schicht eine Dielektrizitätskonstante aufweist, die der des Substrates angepasst ist. Dadurch werden Sprünge der Dielektrizitätskonstante und damit lokale Überhöhungen der elektrischen Felder im Bereich hoher Feldstärken vermieden.

Vorzugsweise enthält das Substrat ein Material mit einer Dielektrizitätskonstante im Bereich von 9 und 25, insbesondere LaAlO₃, MgO, Al₂O₃, YAlO₃. HTS kann auf diesen Materialien besonders einfach und mit guten Schichteigenschaften gewachsen werden.

Vorteilhaft ist auch ein MR-Probenkopf mit einem nach dem erfindungsgemäßen Verfahren hergestellten HF-Resonatorsystem. Das Resonatorsystem ist besonders einfach, schnell, effizient und preiswert auf die Zielfrequenz trimmbar und weist hohe Spannungsfestigkeit, geringe elektrische Verluste und hohe Effizienz auf.

Bei dem erfindungsgemäßen Verfahren zum Abstimmen eines HF-Resonatorsystems gemäß Anspruch 1, wird zumindest in den Bereichen der kapazitiven Elemente der leitfähigen Struktur wenigstens eine dielektrische Schicht mittels Verdampfen, Plasmadeposition, Sputtern oder aus der Lösung Sputtern oder aus der Lösung auf den HF-Resonator aufgebracht, welche nach Auftragung die Bereiche der kapazitiven Elemente zumindest teilweise bedeckt, wobei die lokale Dicke zumindest einer der dielektrischen Schichten in Abhängigkeit von der Resonanzfrequenz des unbeschichteten Resonators, einer Zielresonanzfrequenz des beschichteten Resonators, der Dielektrizitätskonstante des Substrats und den Dielektrizitätskonstanten der Materialien der dielektrischen Schichten gewählt wird.

Das Einstellen der gewünschten Resonanzfrequenz erfolgt über die Wahl der Dicke der dielektrischen Schichten. Dabei reicht es prinzipiell aus, zumindest einen Bereich, an dem ein hohes elektrisches Feld herrscht, mit einer dielektrischen Schicht zu bedecken. Um das Resonatorsystem zusätzlich gegen Durchschläge zu schützen, ist es vorteilhaft sämtliche Bereiche, in denen die E-Felder am höchsten sind, zu beschichten, um die E-Felder möglichst homogen über den Raum zu verteilen und insbesondere an Spitzen und Kanten allzu hohe Sprünge der Dielektrizitätskonstante zu vermeiden. Die dielektrische Schicht kann dabei an unterschiedlichen Stellen des Resonators unterschiedlich dick aufgetragen werde, so dass die lokalen Dicken der Schicht über die Fläche des Resonators variiert. Wenn zusätzlich noch eine möglichst homogene Stromverteilung erreicht werden soll, ist es vorteilhaft, wenn die Fläche des Resonators, auf der die leitfähigen Strukturen aufgebracht sind, mit der oder den dielektrischen Schichten vollständig bedeckt ist. Die Bedeckung sollte dann über die Fläche des Resonatorsystems weitestgehend gleichmäßig sein, d.h. die Dickenvariationen sollten möglichst unter 10% liegen. Für solche Resonatorsysteme lässt sich die Verteilung der Stromdichte in den Leiterelementen besonders einfach berechnen und Anpassen und die Anpassung ist von der eingestellten Resonanzfrequenz, d.h. dem Trimmen weitestgehend unabhängig.

Bei einer vorteilhaften Variante des erfindungsgemäßen Verfahrens wird nach Auftragen einer ersten dielektrischen Schicht eine weitere dielektrische Schicht auf die erste dielektrische Schicht und/oder auf die die leitfähige Struktur aufgebracht. Auf diese Weise kann beispielsweise eine Beschichtung mit einem Gradienten bezüglich der Dielektrizitätskonstante realisiert werden oder eine erste Schicht die besser gegen Spannungsdurchschläge geeignet ist aufgebracht werden.

Bei einer vorteilhaften Variante des erfindungsgemäßen Verfahrens wird nach Auftragen einer dielektrischen Schicht ein Teil dieser Schicht wieder abgetragen, insbesondere durch einen Ätzprozess. Auf diese Weise können Korrekturen der lokalen Dicke nach der Abscheidung durchgeführt werden, insbesondere wenn die Dickenkontrolle beim Aufbringen der Schichten nicht ausreichend präzise ist oder wenn mehrere Resonatoren zugleich beschichtet werden sollen obwohl das Trimmen der Resonatoren verschiedene Schichtdicken erfordert. Auf diese Weise kann besonders preisgünstig beschichtet werden.

Zum Einstellen der Dicken der dielektrischen Schichten ist es vorteilhaft, wenn zwischen dem Auftragen der ersten dielektrischen Schicht und der weiteren dielektrischen Schicht eine Bestimmung der Resonanzfrequenz des mit der ersten dielektrischen Schicht beschichteten HF-Resonators erfolgt. Damit können Fehler in der Beschichtungsdicke der ersten Schicht korrigiert werden. Weiterhin kann ein iteratives Verfahren mit vielen Schichten zum Trimmen verwendet werden.

Eine Methode bei der besonders hohe Ausbeute erreicht werden kann sieht vor nach Auftragen der ersten dielektrischen Schicht Paare von HF-Resonatoren verschiedener Resonanzfrequenzen zu einem Helmholtzpaar zu montieren, wobei die Zielfrequenzen der einzelnen Resonatoren eine Funktion der Zielfrequenz des Paares und der Kopplung zwischen den Resonatoren (abhängig z.B. vom Abstand) ist.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1a: eine schematische Schnittdarstellung eines Bereiches kapazitiver Elemente eines Resonators mit leitfähigen Strukturen;
- Fig. 1b: eine schematische Schnittdarstellung eines Bereiches kapazitiver Elemente eines nach dem erfindungsgemäßen Verfahren hergestellten Resonators, bei dem die leitfähigen Strukturen mit einer dünnen dielektrischen Schicht beschichtet sind:
- Fig. 1c: eine schematische Schnittdarstellung eines Bereiches kapazitiver Elemente eines nach dem erfindungsgemäßen Verfahren hergestellten Resonators bei dem die leitfähigen Strukturen mit einer dicken dielektrischen Schicht beschichtet sind:
- Fig. 2: eine schematische Schnittdarstellung eines nach dem erfindungsgemäßen Verfahren hergestellten Resonators, bei dem die leitfähigen Strukturen mit zwei dielektrischen Schichten beschichtet sind;
- Fig. 3a: eine grafische Darstellung der Resonanzfrequenz eines nach dem erfindungsgemäßen Verfahren hergestellten Resonators mit lokalisierten Kapazitäten in Abhängigkeit von der Schichtdicke der dielektrischen Schicht;
- Fig. 3b: eine grafische Darstellung der Resonanzfrequenz eines Spiralresonators in Abhängigkeit von der Schichtdicke der dielektrischen Schicht;
- Fig. 4a: eine schematische Schnittdarstellung einer Variante eines Resonators mit doppelseitig beschichtetem Substrat;
- Fig. 4b, 4c: Eine Aufsichtsdarstellung der leitfähigen Strukturen des Resonatorsystems aus Fig. 4a;
- Fig. 5: eine schematische Darstellung eines nach einem Lasertrimmprozesses nach dem Stand der Technik getrimmten Resonators mit gleichmäßiger Trimmung der Kapazitäten; und
- Fig. 6: eine schematische Darstellung eines weiteren nach einem Lasertrimmprozesses nach dem Stand der Technik getrimmten Resonators.

Bei dem erfindungsgemäßen Verfahren wird die gewünschte Resonanzfrequenz der Resonatoren durch Verändern der Kapazitäten ohne Veränderung der leitfähigen Strukturen (Leiterbahnen) eingestellt. Hierzu wird der Resonator mit einem Dielektrikum beschichtet, wobei die Resonanzfrequenz durch die Wahl der Dicke der dielektrischen Schicht bestimmt ist.

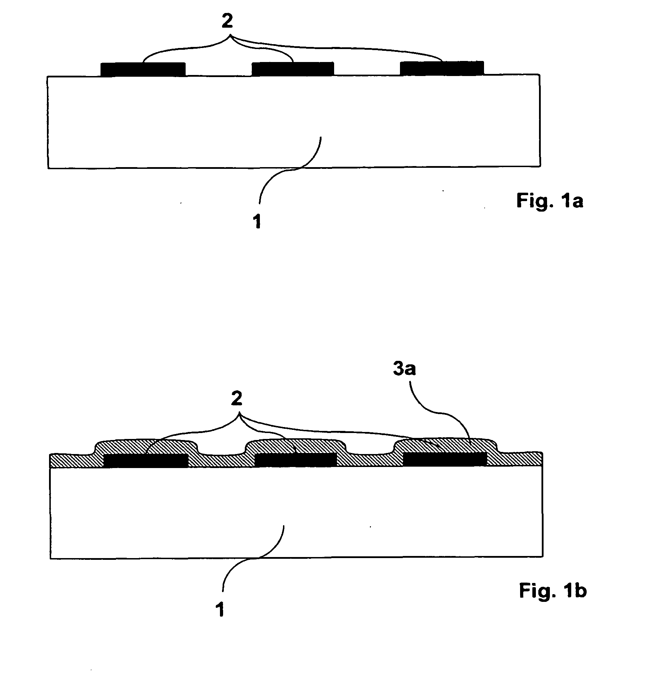

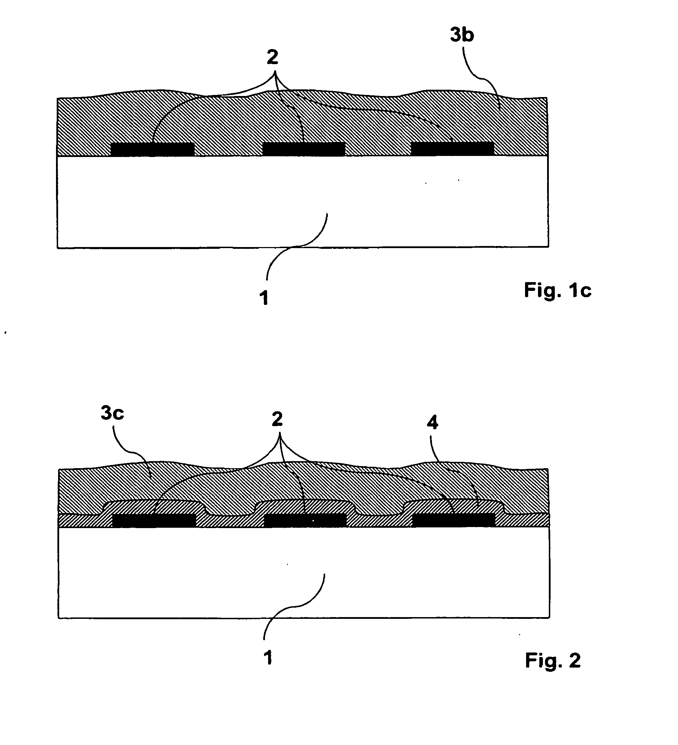

Fig. 1a zeigt einen Schnitt durch ein Substrat **1** und die leitfähigen Strukturen (Leiterbahnen **2)** z.B. innerhalb von Finger-Kapazitäten eines HTS-Resonators oder Leiterbahnen von Spiralresonatoren. Fig.1 b zeigt den entsprechenden Resonator, welcher erfindungsgemäß mit einer dielektrischen Schicht **3a** mit geringer Dicke beschichtet ist. In **Fig. 1c** ist ein nach dem erfindungsgemäßen Verfahren hergestellter Resonator mit einer Beschichtung **3b** mit großer Dicke dargestellt. Hinsichtlich einer einfachen Herstellung sind die die nach dem erfindungsgemäßen Verfahren hergestellte Resonatoren, wie in Fig. 1 b und 1 c gezeigt, mit einer flächendeckenden dielektrischen Schicht beschichtet. Es ist jedoch durchaus möglich, nicht relevante Bereiche auszusparen.

Neben der Einstellung der Resonanzfrequenz des Resonatorsystems kann durch die Beschichtung der Resonatoren mit dielektrischen Schichten auch die Spannungsfestigkeit des Resonatorsystems erhöht werden. Damit können Resonatoren mit höherer Pulsleistung betrieben werden und kürzere Pulswinkel erreichen, was insbesondere für die Anwendung in der NMR vorteilhaft ist.

Bezüglich der Spannungsfestigkeit ist es von Vorteil, eine möglichst gute Überdeckung der Strom tragenden Elemente (Leiterbahnen 2) mit einer dielektrischen Schicht 3a, 3b zu erreichen. Weiterhin ist es vorteilhaft, Sprünge von Dielektrizitätskonstanten möglichst klein zu halten, insbesondere im Bereich hoher elektrischer Feldstärken. Diese Sprünge führen zu Spannungsspitzen und damit elektrischen Durchschlägen. Dielektrizitätssprünge sollten nach Möglichkeit im Bereich geringer elektrischer Felder, d.h. weit entfernt von den Leiterbahnen stattfinden.

Prinzipiell ist lediglich eine einzige dielektrische Schicht notwendig, um die vorgegebene Resonanzfrequenz des Resonators zu realisieren. Es kann jedoch von Vorteil sein, zusätzlich zu einer Trimmschicht eine dünne dielektrische Schicht (Schutzschicht) gegen Spannungsdurchschläge vorzusehen, deren Dielektrizitätskonstante der des Substrats 1 ähnlich ist. Hierdurch können Spannungsdurchschläge verhindert oder zumindest vermindert werden. Es ist daher besonders vorteilhaft, wenn die Leiterbahnen 2 zunächst mit einem Material ähnlicher Dielektrizitätskonstante wie der des Substrats "eingepackt" werden (Schutzschicht **4**) und das Trimmen dann in einem Außenbereich mit einer zweiten dielektrischen Schicht **3c** (Trimmschicht) stattfindet **(****Fig. 2**)**.** Hierbei kann für die Trimmschicht 3c dasselbe Material wie für die Schutzschicht 4 oder ein Material mit höherer oder niedrigerer Dielektrizitätskonstante verwendet werden. Da die Feldstärken im Außenbereich, also im Bereich der Trimmschicht 3c, deutlich niedriger ausfallen als nahe an den Leiterbahnen ist die Problematik des Sprunges der Dielektrizitätskonstante entschärft. Daher kann die Trimmschicht 3c auch aus einem Material mit höherer Dielektrizitätskonstante bestehen ohne die Spannungsfestigkeit der Resonatoren zu reduzieren. Dadurch kann ein ausreichender Trimmbereich auch dann gewährleistet werden, wenn die Trimmschicht relativ weit von den Leiterbahnen entfernt ist.

Idealerweise wird die Beschichtung (Schutzschicht 4 und Trimmschicht 3c) als Gradient mit sinkender Dielektrizitätskonstante bei wachsendem Abstand von den Leiterbahnen 2 ausgeführt. Dies ist allerdings nur dann wichtig, wenn die Schichtung sehr dünn ausgeführt wird, und technologisch extrem aufwändig. Ein solcher Gradient kann z.B. durch die Ausbildung einer Überstruktur (Superlattice) aus zwei oder mehreren verschiedenen Materialien erfolgen.

Eventuell kann es auch notwendig sein zusätzlich eine Haftschicht auf das Substrat 1 und/oder die Leiterbahnen aufzubringen um eine zuverlässige Haftung der Trimmschicht 3a, 3b oder der Schutzschicht 4 auf den Resonatoren und/oder den Substraten 1 gewährleisten zu können. Falls die Schichtdicke der Haftschicht nicht vernachlässigbar ist müssen auch ihre dielektrischen Eigenschaften bei der Bestimmung der Dicke der Trimmschicht 3a, 3b, 3c mit in Betracht gezogen werden.

Die erfindungsgemäße Beschichtung kann entweder einzeln auf die Resonatoren aufgetragen werden oder auf gepaarte Resonatoren (Helmholzpaare). Im zweiten Falle können die Montagetoleranzen die beim Paaren von Resonatoren auftreten und zu Frequenzdifferenzen im Bereich von bis zu 3-5 MHz führen können kompensiert werden. Alternativ kann ein Teil der Fertigungstoleranzen der Resonatoren durch eine gezielte Variation des Abstandes der einzelnen Resonatoren im Helmholzpaar korrigiert werden und/oder durch das Paaren eines Resonators mit zu hoher Resonanzfrequenz mit einem Resonator mit zu niedriger Resonanzfrequenz kann die Ausbeute der Resonatorherstellung erhöht werden. Werden diese oder ähnliche Methoden verwendet, so wird der notwendige Trimmbereich geringer, und dünnere Schichten 3a, 3b, 3c können verwendet werden. Dies ist besonders dann von Vorteil, wenn die dielektrischen Verluste der Trimmschichten 3a, 3b, 3c die Resonatorgüten stark beeinflussen. In diesen Fällen kann die Güte der Einzelresonatoren sowie des Helmholzpaares möglichst hoch gestaltet werden. Die Feldhomogenität des Resonatorpaares wird hierdurch nur geringfügig verändert, solange die Frequenzdifferenz zwischen den Resonatoren nicht allzu groß ausfällt, insbesondere weniger als 5% ist.

Alternativ kann die erste Beschichtung schon so ausgeführt werden, dass jeder Resonator mit verschiedenen Schichtdicken bedeckt wird um die jeweilige Resonanzfrequenz möglichst nahe an eine Zielfrequenz für Einzelresonatoren zu trimmen. Im Anschluss kann durch Justieren des Abstandes der Resonatoren (d.h. durch Verändern der Kopplung) analog zu Referenz [6] eine Feinabstimmung erfolgen.

Ein großer Vorteil der nach dem erfindungsgemäßen Verfahren hergestellten Resonatoren ist es, dass durch Entfernen der Trimmschicht 3a, 3b, 3c der ursprüngliche Zustand der Resonatoren wiederhergestellt werden kann. Das Trimmen verursacht in der Regel keine irreversible Veränderung an den Resonatoren, insbesondere dann nicht, wenn die Trimmschicht 3a, 3b, 3c durch einen mit dem Substrat 1 und dem leitfähigen Material (z.B. HTS-Schicht) kompatiblen Ätzprozess entfernt werden kann.

Zum Einstellen der Dicke der dielektrischen Schichten 3a, 3b, 3c (Trimmen) können herkömmliche Methoden der Dickenbestimmung verwendet werden: Beim Aufbringen der Schicht 3a, 3b, 3c kann die Schichtdicke beispielsweise mittels eines Detektionssystems (z.B. Schwingquarz oder Laserinterferrometer) in situ gemessen werden. Alternativ kann der Resonator während der Deposition der dielektrischen Schichten 3a, 3b, 3c auf Betriebstemperatur gekühlt werden und die Frequenz in situ gemessen werden. Dies vereinfacht das Trimmen, da hierbei die Deposition im richtigen Moment abgebrochen werden kann, ist aber nicht mit allen Materialien/Prozessen kompatibel.

Bei einer alternativen Variante wird zunächst eine für die gewünschte Resonanzfrequenz "zu dicke" dielektrische Schicht aufgebracht, die anschließend auf die benötigte Dicke abgeätzt wird. Hierbei kann ebenso wie bei der Deposition in situ die Frequenz gemessen werden, wenn der Resonator auf Betriebstemperatur gekühlt wird. In diesem Falle erfolgt das Ätzen mittels Plasmaprozessen (wie z.B. reaktivem Ionen Ätzen RIE) oder Ionenstrahlätzen. Alternativ kann auch mit nasschemischen Prozessen geätzt werden. Wird das Ätzen ohne in situ-Messung durchgeführt, so bietet es sich an, die Frequenz mittels einer iterativen Prozedur einzustellen, außer der Ätzprozess kann so genau kalibriert werden, dass die notwendige Ätzzeit berechnet werden kann.

Ein Ablauf zur Montage eines nach dem erfindungsgemäßen Verfahren hergestellten Resonatorsystems kann demnach folgendermaßen aussehen:
1. Beschichtung der Resonatoren mit einer dielektrischen Schicht 4 gegen Spannungsdurchschläge.
2. Charakterisierung der Resonatoren nach Resonanzfrequenz.
3. Paaren von Resonatoren verschiedener Resonanzfrequenzen und Montage zu einem Helmholzpaar. Ziel ist es hierbei eine Resonanzfrequenz des Helmholtzmodes zu treffen, die möglichst nahe an der vorgegebenen Zielfrequenz liegt.
4. Korrektur der Resonanzfrequenz durch Beschichten des Resonatorsystems mit einer weiteren dielektrischer Schicht 3c oder durch kontrolliertes Abätzen der Schicht aus Schritt 1.

Die lokale Dicke der dielektrischen Schichten 3a, 3b, 3c, 4 sind in den gezeigten Beispielen nahezu konstant über die Fläche des Resonators. Es kann jedoch vorteilhaft sein, die lokale Dicke über die Fläche des Resonators zu variieren.

Die Schichtdicken, in denen HTS-Schichten hergestellt werden liegen bei für Hochfrequenzanwendungen geeigneten Substraten typischerweise unter 500 nm, eventuell aber bei mehreren µm (z.B. bei Verwendung von MgO). Die dielektrischen Schichten 3a, 3b, 3c sollten möglichst dicker ausfallen als die elektrisch leitenden Strukturen 2, damit eine gute Beschichtung auch an den Kanten der Leiterbahnen 2 gewährleistet werden kann.

Der Trimmbereich, der durch die dielektrische Schicht 3a, 3b 3c einstellbar ist hängt von der dielektrischen Konstante des Substrates 1 und der Schicht 3a, 3b, 3c, 4 sowie vom Resonatordesign ab:

Typische Werte der dielektrischen Konstante für Substrate 1, die für HTS-Schichten verwendet werden (LaAlO₃, MgO, Saphir, YAlO₃) sind im Bereich ε = 9-25.

Die dielektrischen Konstanten sinnvoller dielektrischer Schichten 3a, 3b, 3c liegen im Bereich 2-26, wobei besonders polymere Schichten wie Parylene, und fluorierte Polymere wie PTFE, FEP, PFA etc. nützlich sind. Parylene hat den Vorzug, dass die Abscheidung bei Raumtemperatur oder kälter vollständig isotrop aus der Gasphase erfolgt. Dies reduziert das Risiko der Beschädigung der leitfähigen Strukturen 2 (HTS-Film) durch Überhitzung und chemische Degradation. Fluorierte Polymere werden eher aus der Lösung abgeschieden und anschließend bei relativ hohen Temperaturen polymerisiert, was die Dickenkontrolle der dielektrischen Schicht 3a, 3b, 3c schwierig gestaltet und die HTS-Filme beschädigen kann. Es gibt allerdings auch Methoden die Fluoropolymere im Plasma abzuscheiden, wobei Dicken und Temperaturkontrolle ähnlich zum Paryleneprozess möglich sind.

Weiterhin sind Oxyde und Nitride sehr einfach abzuscheiden, z.B. durch Sputtern, Verdampfen, Plasmadeposition, etc. Hierbei sind von Interesse Ceroxyd, Siliziumoxyd, Siliziumnitrid, Silikate, Aluminiumoxyd, Titanoxyd, Zirkonoxyd, Zirkonsilikat, Hafniumoxyd, Hafniumsilikat sowie weitere Materialien, insbesondere Al₂O₃, Gd₂O₃, Yb₂O₃, Dy₂O₃, Nb₂O₅, Y₂O₃, La₂O₃, ZrO₂, HfO₂, TiO₂, Ta₂O₅, SrTiO₃, BaₓSr₁₋ₓTiO₃, ZrₓSi₁₋ₓO_{y}, HfₓSi₁-ₓO_{y}, AlₓZr₁₋ₓO₂, Pr₂O₃ etc.

Neben den kontrollierbaren Abscheidebedingungen und der Dielektrizitätskonstante gibt es eine Vielzahl weiterer Anforderungen and die dielektrischen Schichten 3a, 3b, 3c. Diese können in mechanische/prozesstechnische Eigenschaften sowie in elektrische eingeteilt werden:

Bezüglich der mechanischen/prozesstechnischen Eigenschaften ist die Haftung auf dem Substrat und auf der HTS-Schicht wichtig. Abplatzen und Reißen der dielektrischen Schicht sollte auch bei vielfachem Zyklieren von 2 K bis 400 K nicht auftreten. Die dielektrische Schicht sollte möglichst kontrolliert ätzbar sein, um Dickenkorrekturen nach der Abscheidung durchführen zu können. Weiterhin sollte die dielektrische Schicht eine chemische Barriere gegenüber Substanzen bilden, welche die HTS-Schichten zerstören können (insbesondere Wasser, Säuren und Laugen). Sie sollte chemisch so resistent sein, dass sie mit gängigen Reinigungsprozessen insbesondere mit Lösungsmitteln wie Alkoholen und Aceton kompatibel ist.

Die wichtigste elektrische Eigenschaft der erfindungsgemäßen dielektrischen Schicht neben der Dielektrizitätskonstante sind möglichst geringe dielektrische Verluste (d.h. möglichst kleiner Verlustfaktor tan δ), sowie geringe elektrische Leitfähigkeit um die Güte der HTS-Resonatoren nicht zu ruinieren. Weiterhin sollte die dielektrische Konstante möglichst temperaturunabhängig sein. Dies reduziert die Anforderungen and die Temperaturstabilität der Resonatoren im Betrieb. Insbesondere dürfen kurzzeitige Erwärmungen der Resonatoren durch das Einstrahlen von gepulster oder CW (continuous wave)-HF-Leistung nicht zu einem Verstimmen führen. Darüber hinaus sollte die Spannungsfestigkeit möglichst hoch sein um elektrischen Entladungen vorzubeugen.

In den Fig. 2a und 2b sind zwei Beispiele für den Frequenzverlauf von Resonatoren mit verschiedenen Resonanzfrequenzen und verschiedenen Designs aber derselben Beschichtung (Parylene N) in Abhängigkeit von der Dicke der Parylene N-Schicht gezeigt. Bei den Substraten handelt es sich jeweils um Saphir mit einer dielektrischen Konstante von ca. 10.

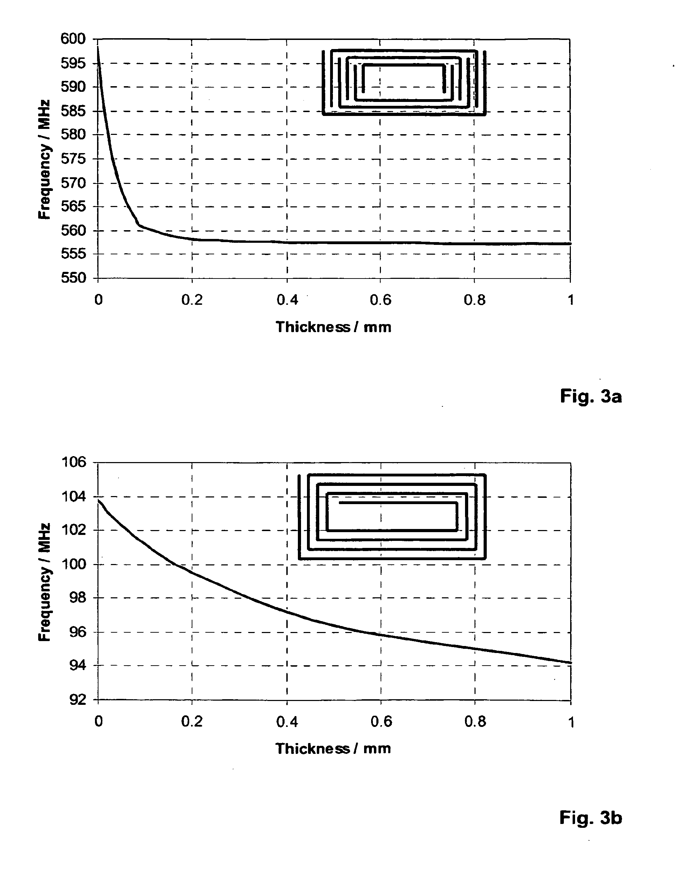

In dem in **Fig. 3a** gezeigten Fall ist der Resonator vom Typ "Resonator mit lokalisierten Kapazitäten". Diese werden durch Überlappung von Leiterbahnen in bestimmten Bereichen des Resonators erzeugt ("Fingerkondensatoren"), wie schematisch dargestellt. Bei Beschichtung sinkt die Resonanzfrequenz in diesem konkreten Fall um ca. 40 MHz (entsprechend ca. 6.5%). Dabei findet im Bereich bis 100 µm quasi die gesamte Frequenzverschiebung statt. Mit weiter zunehmender Dicke der dielektrischen Schicht sinkt die Resonanzfrequenz um lediglich weitere 3 MHz (entsprechend ca. 0.5%). Dies ist eine sehr vorteilhafte Situation, da der Trimmbereich in der Regel in der Größenordnung von 1% der Resonanzfrequenz liegt. Für solche Resonatoren kann daher mit einer sehr dünnen dielektrischen Schicht von weniger als 10 µm getrimmt werden.

Resonatoren vom Typ "Resonator mit verteilter Kapazität" verhalten sich identisch zu dem in Fig. 3a dargestellten Resonator mit lokalisierten Kapazitäten. In der Regel sind die Resonatoren Mischtypen aus diesen beiden Grundtypen.

Der zweite Resonatortyp, welcher vom erfindungsgemäßen Verfahren nicht erfaßt wird und der in **Fig. 3b** dargestellt ist, ist ein "Spiralresonator". Hierbei ist eine Leiterbahn zur Spirale "aufgewickelt" und bildet in gewissem Rahmen Kapazitäten zwischen sich benachbarten Leiterbahnabschnitten aus. Allerdings ist dieser kapazitive Einfluss hier relativ gering und die Resonanzfrequenz ergibt sich hauptsächlich aus den Stehwelleneigenschaften. Dementsprechend ist die Frequenzabhängigkeit des Resonators mit einer Beschichtung equivalent zum Beispiel aus Fig. 3a eher flach. Bei einer Beschichtung von 1 mm wird eine Frequenzverschiebung von 10 MHz (entsprechend ca. 10%) erzielt. Eine Sättigung ist nicht zu beobachten. Dies liegt daran, dass die elektrischen Felder solcher Resonatoren nicht lokal begrenzt sind (im Gegensatz zu Resonatoren mit Fingerkapazitäten), sondern sehr weit in den Raum hinausreichen. Zum Trimmen solcher Resonatoren muss daher eine dielektrische Schicht mit hoher Dielektrizitätskonstante und relativ hohen Dicken verwendet werden.

Ähnlich verhält es sich mit Resonatorstrukturen, die auf doppelseitig beschichteten Substraten aufgebracht sind und bei denen die Kapazität hauptsächlich durch das Substrat hindurch definiert ist. Bei solchen Resonatoren ist der Einfluss des Trimmens durch eine Beschichtung viel geringer als bei Resonatoren mit Fingerkondensatoren. Die Schichtdicken müssen daher relativ groß gewählt werden.

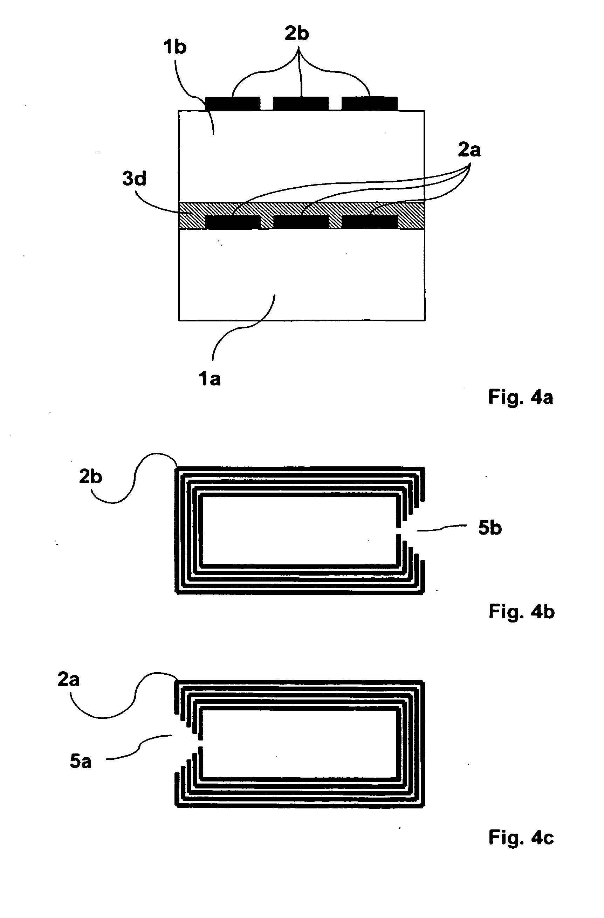

Um dem entgegenzuwirken, werden zwei Resonatoren aufeinander montiert. Ein solches Resonatorsystem ist in **Fig. 4a** dargestellt. Auf den beiden Substraten 1a, 1 b sind jeweils auf einer Seite leitfähige Strukturen 2a, 2b aufgebracht. Die beiden Resonatoren mit den leitfähigen Strukturen 2a, 2b werden so gegeneinander montiert, dass die Öffnungen 5a, 5b der Leiterbahnen 2a, 2b einander entgegengesetzt angeordnet sind, wie in **Fig. 4b** und **Fig. 4c** dargestellt. In dem Beispiel der Fig. 4a sind die Resonatoren so angeordnet, dass die Leiterbahnen 2a des einen Resonators dem Substrat 1b des anderen Resonators zugewandt sind. Die Resonatoren können jedoch auch so montiert werden, dass beide Substrate 1a, 1b aufeinander zu liegen kommen, oder dass beide Substrate 1a, 1b nach außen zeigen und die beiden leitenden Strukturen 2a, 2b lediglich durch ein zusätzliches Dielektrikum getrennt sind. Bei all diesen Resonatortypen kann eine Beschichtung 3d auf einem oder beiden leitfähigen Strukturen 2a, 2b und/oder auf den rückseitigen Substraten 1 a, 1 b zum Trimmen verwendet werden, wobei schon eine sehr dünne dielektrische Schicht 3d einen großen Trimmbereich ermöglicht.

Das erfindungsgemäße Verfahren ist auch bei anderen, beispielsweise bei den in Referenz [7] und den dort zitierten Referenzen beschriebenen, Resonatortypen anwendbar, sofern die kapazitiven Elemente in Form von Fingerkapazitäten ausgebildet sind.

Mit dem erfindungsgemäßen Verfahren können Resonatorsysteme mit hoher Genauigkeit auf eine gewünschte Resonanzfrequenz eingestellt werden. Dabei wird die Gefahr der Beschädigung der leitfähigen Struktur minimiert.

### Referenzen

- [1]: DE3506471
- [2]: US 2005/0256009
- [3]: US 2004/0021466,
- [4]: WO 2004/084340
- [5]: JP 04368006
- [6]: WO 2004102596
- [7]: DE 102004020167

### Bezugszeichenliste

- 1: Substrat
- 1a: Substrat
- 1b: Substrat
- 2: leitfähige Strukturen (Leiterbahnen)
- 2a: leitfähige Strukturen (Leiterbahnen)
- 2b: leitfähige Strukturen (Leiterbahnen)
- 3a: dielektrische Schicht (Trimmschicht)
- 3b: dielektrische Schicht (Trimmschicht)
- 3c: dielektrische Schicht (Trimmschicht)
- 3d: dielektrische Schicht (Trimmschicht)
- 4: dielektrische Schicht (Schutzschicht)
- 5a: Öffnung der leitfähigen Strukturen
- 5b: Öffnung der leitfähigen Strukturen

## Patentansprüche

1. Verfahren zum Abstimmen eines Hochfrequenz(HF)-Resonatorsystems, insbesondere für einen Magnetresonanz(MR)-Probenkopf, umfassend mindestens einen HF-Resonator mit einem Substrat (1), auf dem eine leitfähige Struktur (2) aufgebracht ist; wobei die leitfähige Struktur (2) Bereiche von kapazitiven und induktiven Elementen umfasst, und die kapazitiven Elemente in Form von Fingerkapazitäten ausgebildet sind,
**dadurch gekennzeichnet,**
**dass** auf den HF-Resonator zumindest in den Bereichen der kapazitiven Elemente der leitfähigen Struktur (2) mindestens eine dielektrische Schicht (3a, 3b, 3c, 3d, 4) mittels Verdampfen, Plasmadeposition, Sputtern oder aus der Lösung aufgebracht wird, welche die Bereiche der kapazitiven Elemente zumindest teilweise bedeckt, wobei die dielektrische Schicht bzw. Schichten (3a, 3b, 3c, 3d, 4) in ihrer Dicke, welche ortsabhängig variieren kann, so ausgestaltet werden, daß, abhängig von der Resonanzfrequenz des unbeschichteten HF-Resonators, von der Dielektrizitätskonstante des Substrats (1) und von den Dielektrizitätskonstanten der Materialien der dielektrischen Schichten (3a, 3b, 3c, 3d, 4) eine gewünschte Resonanzfrequenz eingestellt wird.

2. Verfahren nach Anspruch 1, **dadurch gekennzeichnet, dass** nach Auftragen einer ersten dielektrischen Schicht (3a, 3b, 3d, 4) eine weitere dielektrische Schicht (3c) auf die erste dielektrische Schicht (3a, 3b, 3d, 4) und/oder auf die die leitfähige Struktur (2) aufgebracht wird.

3. Verfahren nach einem der vorhergehenden Ansprüche **dadurch gekennzeichnet, dass** zum Einstellen der Dicke der dielektrischen schicht bzw. einer der dielektrischen Schichten nach Auftragen der dielektrischen Schicht (3a, 3b, 3c, 3d, 4) ein Teil dieser Schicht (3a, 3b, 3c, 3d, 4) wieder abgetragen wird, insbesondere durch einen Ätzprozess.

4. Verfahren nach einem der vorhergehenden Ansprüche, **dadurch gekennzeichnet, dass** zwischen dem Auftragen der ersten dielektrischen Schicht (3a, 3b, 3d, 4) und einer weiteren dielektrischen Schicht (3c) eine Bestimmung der Resonanzfrequenz des mit der ersten dielektrischen Schicht (3a, 3b, 3d, 4) beschichteten HF-Resonators erfolgt.

5. Verfahren nach einem der vorhergehenden Ansprüche, **dadurch gekennzeichnet, dass** nach Auftragen der ersten dielektrischen Schicht (3a, 3b, 3d, 4) Paare von HF-Resonatoren verschiedener Resonanzfrequenzen zu einem Helmholtzpaar montiert werden.

6. Verfahren nach einem der vorhergehenden Ansprüche, **dadurch gekennzeichnet, dass** die Dicke mindestens einer der dielektrischen Schichten (3a, 3b, 3c, 3d, 4) in allen Bereichen des HF-Resonators gleich gewählt wird.

7. Verfahren nach einem der vorhergehenden Ansprüche, **dadurch gekennzeichnet, dass** zumindest eine der dielektrischen Schichten (3a, 3b, 3c, 3d, 4) die Bereiche der kapazitiven Elemente vollständig bedeckt.

8. Verfahren nach einem der vorhergehenden Ansprüche, **dadurch gekennzeichnet, dass** für zumindest eine der dielektrischen Schichten (3a, 3b, 3c, 3d, 4) ein Material mit einer Dielektrizitätskonstante im Bereich zweischen 2 und 26 verwendet wird.

9. Verfahren nach einem der vorhergehenden Ansprüche, **dadurch gekennzeichnet, dass** für zumindest eine der dielektrischen Schichten (3a, 3b, 3c, 3d, 4) ein Material verwendet wird, welches gegen Lösungsmittel, insbesondere gegen Alkohol und/oder Aceton und/oder Wasser, chemisch resistent, und, insbesondere für Wasserdampf, nicht permeabel ist.

10. Verfahren nach einem der vorhergehenden Ansprüche, **dadurch gekennzeichnet, dass** für zumindest eine der dielektrischen Schichten (3a, 3b, 3c, 3d, 4) ein Material verwendet wird, welches eine elektrische Leitfähigkeit s mit s < 10⁻³ S/m, vorzugsweise s < 10⁻⁵ S/m, insbesondere s < 10⁻⁸ S/m, und/oder einen geringen Verlustfaktor tan δ aufweist, wobei tan δ < 10⁻³, insbesondere tan δ < 10⁻⁵.

11. Verfahren nach einem der vorhergehenden Ansprüche, **dadurch gekennzeichnet, dass** für die dielektrischen Schichten (3a, 3b, 3c, 3d, 4) Materialien verwendet werden, welche eine weitestgehend temperaturunabhängige Dielektrizitätskonstante aufweisen.

12. Verfahren nach einem der vorhergehenden Ansprüche, **dadurch gekennzeichnet, dass** für zumindest eine der dielektrischen Schichten (3a, 3b, 3c, 3d, 4) ein Material verwendet wird, das Polymere, insbesondere Parylene, und/oder fluorierte Polymere, insbesondere FEP, PFA, PTFE, und/oder Oxyde und/oder Nitride enthält.

13. Verfahren einem der vorhergehenden Ansprüche, **dadurch gekennzeichnet, dass** zumindest eine der dielektrischen Schichten (3a, 3b, 3c, 3d, 4) eine Spannungsfestigkeit aufweist, die größer als 10⁷ V/m, insbesondere größer als 10⁸ V/m ist.

14. Verfahren nach einem der Ansprüche 2 bis 13, **dadurch gekennzeichnet, dass** für die erste dielektrischen Schicht (4) ein Material verwendet wird, das eine ähnliche Dielektrizitätskonstante wie das Substrat (1) aufweist, wobei die Dielektrizitiätskonstante der ersten dielektrischen Schicht (4) insbesondere zwischen dem halben und dem doppelten Wert der Dielektrizitätskonstante des Substrates (1) liegt.

15. Verfahren nach einem der Ansprüche 7 bis 14, **dadurch gekennzeichnet, dass** die Dielektrizitätskonstanten der dielektrischen Schichten (3a, 3b, 3c, 3d, 4), mit steigendem Abstand von der leitfähigen Struktur (2) abnehmend gewählt werden, so dass durch Auftragung mehrerer dielektrischen Schichten (3a, 3b, 3c, 3d, 4), ein Gradient bezüglich der Dielektrizitätskonstante realisiert wird.

## Claims

1. Method for tuning a radio frequency (RF) resonator system, in particular, for a magnetic resonance (MR) probe head, comprising at least one RF resonator with a substrate (1), on which a conductive structure (2) is applied, wherein the conductive structure (2) comprises regions of capacitive and inductive elements, and the capacitive elements are designed in the form of finger capacities,
**characterized in that**
at least one dielectric layer (3a, 3b, 3c, 3d, 4) is applied to the RF resonator at least in the regions of the capacitive elements of the conductive structure (2) by evaporation, plasma deposition, sputtering or from the solution, which at least partially covers the regions of the capacitive elements, wherein the thickness, which can vary in dependence on the position, of the dielectric layer(s) (3a, 3b, 3c, 3d, 4) is designed in such a manner that a desired resonance frequency is adjusted in dependence on the resonance frequency of the uncoated RF resonator, on the dielectric constant of the substrate (1) and on the dielectric constants of the materials of the dielectric layers (3a, 3b, 3c, 3d, 4).

2. Method according to claim 1, **characterized in that**, after application of a first dielectric layer (3a, 3b, 3d, 4), a further dielectric layer (3c) is applied to the first dielectric layer (3a, 3b, 3d, 4) and/or to the conductive structure (2).

3. Method according to any one of the preceding claims, **characterized in that**, after application of the dielectric layer (3a, 3b, 3c, 3d, 4) part of this layer (3a, 3b, 3c, 3d, 4) is removed again, in particular, by an etching process, for adjusting the thickness of the dielectric layer or of one of the dielectric layers respectively.

4. Method according to any one of the preceding claims, **characterized in that** between application of the first dielectric layer (3a, 3b, 3d, 4) and of a further dielectric layer (3c), the resonance frequency of the RF resonator coated with the first dielectric layer (3a, 3b, 3d, 4) is determined.

5. Method according to any one of the preceding claims, **characterized in that**, after application of the first dielectric layer (3a, 3b, 3d, 4), pairs of RF resonators with different resonance frequencies are mounted to form a Helmholtz pair.

6. Method according to any one of the preceding claims, **characterized in that** the thickness of at least one of the dielectric layers (3a, 3b, 3c, 3d, 4) is selected to be the same in all regions of the RF resonator.

7. Method according to any one of the preceding claims, **characterized in that** at least one of the dielectric layers (3a, 3b, 3c, 3d, 4) completely covers the regions of the capacitive elements.

8. Method according to any one of the preceding claims, **characterized in that** a material with a dielectric constant in the range between 2 and 26 is used for at least one of the dielectric layers (3a, 3b, 3c, 3d, 4).

9. Method according to any one of the preceding claims, **characterized in that** a material, which is chemically resistant to solvents, in particular, to alcohol and/or acetone and/or water, and is impermeable, in particular to water vapor, is used for at least one of the dielectric layers (3a, 3b, 3c, 3d, 4).

10. Method according to any one of the preceding claims, **characterized in that** a material, which exhibits an electrical conductivity s, where s < 10⁻³ S/m, preferably s < 10⁻⁵ S/m, in particular, s < 10⁻⁸ S/m and/or a low loss factor tan δ, where tan δ < 10⁻³, in particular, tan δ < 10⁻⁵, is used for at least one of the dielectric layers (3a, 3b, 3c, 3d, 4).

11. Method according to any one of the preceding claims, **characterized in that** materials having a largely temperature-independent dielectric constant are used for the dielectric layers (3a, 3b, 3c, 3d, 4).

12. Method according to any one of the preceding claims, **characterized in that** a material, which contains polymers, in particular, parylenes, and/or fluorinated polymers, in particular, FEP, PFA, PTFE, and/or oxides and/or nitrides, is used for at least one of the dielectric layers (3a, 3b, 3c, 3d, 4).

13. Method according to any one of the preceding claims, **characterized in that** at least one of the dielectric layers (3a, 3b, 3c, 3d, 4) exhibits an electric strength that is greater than 10⁷ V/m, in particular greater than 10⁸ V/m.

14. Method according to any one of the claims 2 through 13, **characterized in that** a material, which exhibits a dielectric constant similar to that of the substrate (1), is used for the first dielectric layer (4), wherein the dielectric constant of the first dielectric layer (4) is, in particular, between half and double the value of the dielectric constant of the substrate (1).

15. Method according to any one of the claims 7 through 14, **characterized in that** the dielectric constants of the dielectric layers (3a, 3b, 3c, 3d, 4) decrease as the distance from the conductive structure (2) increases such that by application of several dielectric layers (3a, 3b, 3c, 3d, 4) a dielectric constant gradient is realized.

## Revendications

1. Procédé pour accorder un système de résonateur à haute fréquence (HF), en particulier pour une tête de mesure à résonance magnétique (RM), comprenant au moins un résonateur HF avec un substrat (1) sur lequel est appliquée une structure conductrice (2), la structure conductrice (2) comprenant des zones d'éléments capacitifs et inductifs et les éléments capacitifs étant réalisés sous la forme de condensateurs à doigts,
**caractérisé en ce**
**qu'**au moins une couche diélectrique (3a, 3b, 3c, 3d, 4) est appliquée sur le résonateur HF, au moins dans les zones des éléments capacitifs de la structure conductrice (2), par vaporisation, dépôt assisté par plasma, projection ou à partir d'une solution, laquelle couche diélectrique (3a, 3b, 3c, 3d, 4) recouvre au moins partiellement les zones des éléments capacitifs, la ou les couches diélectriques (3a, 3b, 3c, 3d, 4) étant réalisées dans leur épaisseur, qui peut varier localement, de façon qu'en fonction de la fréquence de résonance du résonateur HF non revêtu, une fréquence de résonance souhaitée soit réglée par la constante diélectrique du substrat (1) et par les constantes diélectriques des matériaux des couches diélectriques (3a, 3b, 3c, 3d, 4).

2. Procédé selon la revendication 1, **caractérisé en ce qu'**après application d'une première couche diélectrique (3a, 3b, 3d, 4), une autre couche diélectrique (3c) est appliquée sur la première couche diélectrique (3a, 3b, 3d, 4) et/ou sur la structure conductrice (2).

3. Procédé selon une des revendications précédentes, **caractérisé en ce qu'**après application de la couche diélectrique (3a, 3b, 3c, 3d, 4), une partie de cette couche (3a, 3b, 3c, 3d, 4) est de nouveau enlevée, en particulier par un processus de gravure, pour régler l'épaisseur de la couche diélectrique ou d'une des couches diélectriques.

4. Procédé selon une des revendications précédentes, **caractérisé en ce qu'**entre l'application de la première couche diélectrique (3a, 3b, 3d, 4) et d'une autre couche diélectrique (3c), une détermination de la fréquence de résonance du résonateur HF revêtu de la première couche diélectrique (3a, 3b, 3d, 4) est effectuée.

5. Procédé selon une des revendications précédentes, **caractérisé en ce qu'**après application de la première couche diélectrique (3a, 3b, 3d, 4), des paires de résonateurs HF de différentes fréquences de résonance sont montées en une paire de Helmholtz.

6. Procédé selon une des revendications précédentes, **caractérisé en ce que** l'épaisseur d'au moins une des couches diélectriques (3a, 3b, 3c, 3d, 4) est choisie égale dans toutes les zones du résonateur HF.

7. Procédé selon une des revendications précédentes, **caractérisé en ce qu'**au moins une des couches diélectriques (3a, 3b, 3c, 3d, 4) recouvre complètement les zones des éléments capacitifs.

8. Procédé selon une des revendications précédentes, **caractérisé en ce que** l'on utilise pour au moins une des couches diélectriques (3a, 3b, 3c, 3d, 4) un matériau ayant une constante diélectrique comprise entre 2 et 26.

9. Procédé selon une des revendications précédentes, **caractérisé en ce que** l'on utilise pour au moins une des couches diélectriques (3a, 3b, 3c, 3d, 4) un matériau chimiquement résistant aux solvants, en particulier à l'alcool et/ou à l'acétone et/ou à l'eau et non perméable, en particulier à la vapeur d'eau.

10. Procédé selon une des revendications précédentes, **caractérisé en ce que** l'on utilise pour au moins une des couches diélectriques (3a, 3b, 3c, 3d, 4) un matériau qui présente une conductivité s avec s < 10⁻³ S/m, de préférence s < 10⁻⁵ S/m, en particulier s < 10⁻⁸ S/m, et/ou un faible facteur de perte tan δ, avec tan δ < 10⁻³, en particulier tan δ < 10⁻⁵.

11. Procédé selon une des revendications précédentes, **caractérisé en ce que** l'on utilise pour les couches diélectriques (3a, 3b, 3c, 3d, 4) des matériaux qui présentent une constante diélectrique dans une très large mesure indépendante de la température.

12. Procédé selon une des revendications précédentes, **caractérisé en ce que** l'on utilise pour au moins une des couches diélectriques (3a, 3b, 3c, 3d, 4) un matériau qui contient des polymères, en particulier des parylènes, et/ou des polymères fluorés, en particulier FEP, PFA, PTFE, et/ou des oxydes et/ou des nitrures.

13. Procédé selon une des revendications précédentes, **caractérisé en ce qu'**au moins une des couches diélectriques (3a, 3b, 3c, 3d, 4) présente une rigidité diélectrique supérieure à 10⁷ V/m, en particulier supérieure à 10⁸ V/m.

14. Procédé selon une des revendications 2 à 13, **caractérisé en ce que** l'on utilise pour la première couche diélectrique (4) un matériau qui présente une constante diélectrique comparable à celle du substrat (1), la constante diélectrique de la première couche diélectrique (4) se situant en particulier entre la moitié et le double de la constante diélectrique du substrat (1).

15. Procédé selon une des revendications 7 à 14, **caractérisé en ce que** les constantes diélectriques des couches diélectriques (3a, 3b, 3c, 3d, 4) sont choisies décroissantes avec la distance par rapport à la structure conductrice (2), de sorte que l'application de plusieurs couches diélectriques (3a, 3b, 3c, 3d, 4) permet de réaliser un gradient concernant la constante diélectrique.
